# EUROPEAN PATENT APPLICATION

(11) **EP 3 823 065 A1**
(43) Date of publication of application: **19.05.2021**
(21) Application number: 20201303.3
(22) Date of filing: 12.10.2020
(51) Int. Cl.: H01M 4/587, H01M 10/0525, H01M 10/44, H01M 10/48, H02J 7/00

(54) **METHOD FOR CHARGING BATTERY AND CHARGING SYSTEM**

(30) Priority: 15.11.2019 JP 2019207257
(71) Applicant: TOYOTA JIDOSHA KABUSHIKI KAISHA, Toyota-shi, Aichi-ken, 471-8571 (JP)
(72) Inventor: NAGAI, Hiroki, Toyota-shi, Aichi-ken,, 471-8571 (JP); TASHIRO, Hiroki, Toyota-shi, Aichi-ken,, 471-8571 (JP); KUZUBA, Mitsuhiro, Toyota-shi, Aichi-ken,, 471-8571 (JP); KANADA, Ryo, Toyota-shi, Aichi-ken,, 471-8571 (JP)
(74) Representative: Kuhnen & Wacker Patent- und Rechtsanwaltsbüro PartG mbB

(57) **Abstract**

In a method for charging a battery (2), the battery (2) is a lithium ion battery including a graphite-containing negative electrode. A stage structure of the graphite is classified into a stage 1 to a stage 4. The battery (2) includes: an SOC region (X_{L}) where the stage 4 and the stage 3 coexist; an SOC region (X_{M}) where the stage 3 and the stage 2 coexist; and an SOC region (X_{H}) where the stage 2 and the stage 1 coexist. The method includes first and second steps. The first step is estimating an SOC of the battery (2) based on at least one of a voltage (VB) and a current (IB) of the battery (2). The second step is determining a charging current to the battery (2) in accordance with the SOC of the battery (2) such that the charging current in the SOC region (X_{M}) is larger than the charging current in the SOC regions (X_{L} and X_{H}).

## Description

This nonprovisional application is based on Japanese Patent Application No. 2019-207257 filed on November 15, 2019 with the Japan Patent Office, the entire contents of which are hereby incorporated by reference.

### BACKGROUND

### Field

The present disclosure relates to a method for charging a battery and a charging system, and more particularly to the technique for controlling a charging current of a lithium ion battery.

### Description of the Background Art

In recent years, a vehicle having a lithium ion battery (non-aqueous electrolyte secondary battery) mounted thereon as a battery for traveling has been becoming popular. Hereinafter, the lithium ion battery may be abbreviated as "battery". An increase in battery capacity has been under study. By increasing the capacity, an EV traveling distance (distance that can be traveled by the vehicle using electric power stored in the battery) of the vehicle can be lengthened. However, the time required for charging of the battery also becomes longer, which may lead to a reduction in user's convenience. Thus, in order to shorten the charging time, "quick charging" for charging a battery with a large current has been under development.

It is known that deterioration of a battery is likely to progress particularly during quick charging (charging at a high rate). Such deterioration is also referred to as "high rate deterioration" to distinguish it from deterioration over time. The high rate deterioration is considered to result from the occurrence of uneven distribution of a lithium ion concentration in an electrode assembly due to charging. The uneven distribution of the lithium ion concentration may be called "salt concentration unevenness".

The technique for suppressing high rate deterioration during quick charging has been proposed. For example, Japanese Patent Laying-Open No. 2011-024412 discloses a charging system that shortens the battery charging time while suppressing/eliminating an influence of quick charging on a cycle life.

### SUMMARY

In order to extend a life of a battery, there is always a demand for the technique for suppressing high rate deterioration of the battery due to charging (refer to, for example, Japanese Patent Laying-Open No. 2011-024412). As a result of earnest study, the inventors have found a method that allows effective suppression of high rate deterioration.

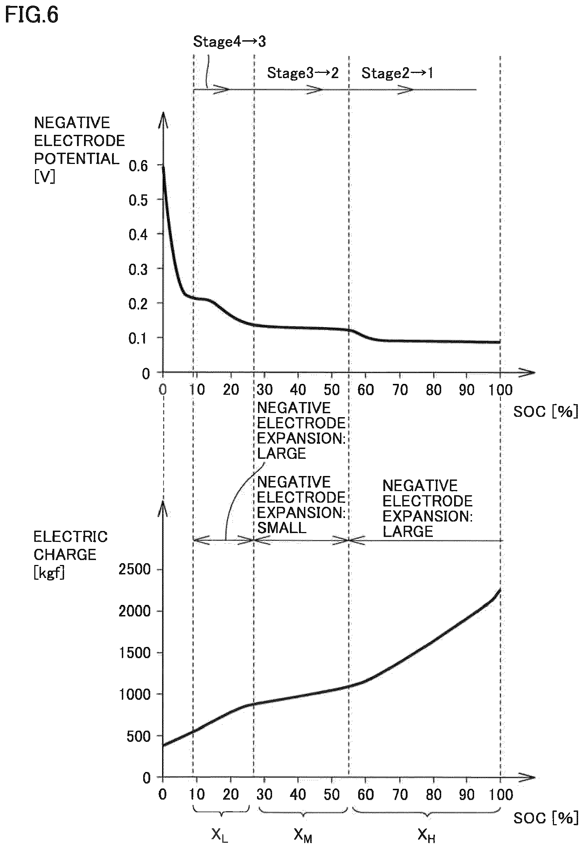

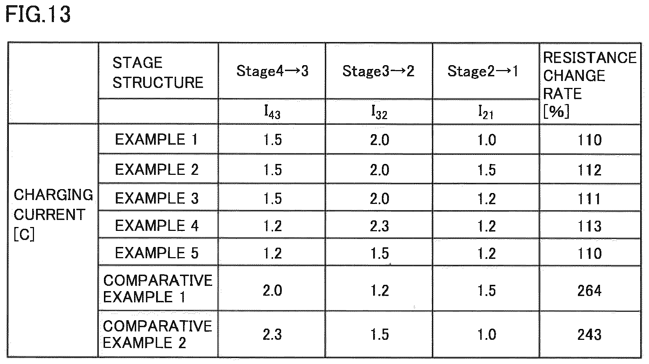

The present disclosure has been made to solve the above-described problem, and an object of the present disclosure is to suppress high rate deterioration of a lithium ion battery.
(1) In a method for charging a battery according to an aspect of the present disclosure, the battery is a lithium ion battery including a graphite-containing negative electrode. A stage structure of the graphite is classified into a stage 1 to a stage 4. The battery includes: a first SOC region where the stage 4 and the stage 3 coexist; a second SOC region where the stage 3 and the stage 2 coexist; and a third SOC region where the stage 2 and the stage 1 coexist. The method includes first and second steps. The first step is estimating an SOC of the battery based on at least one of a voltage and a current of the battery. The second step is determining a charging current to the battery in accordance with the SOC of the battery such that the charging current in the second SOC region is larger than the charging current in the first and third SOC regions.
   Although details are described below, a degree of expansion (expansion rate) of the negative electrode due to charging is lower in the second SOC region than in the first or third SOC region (see Fig. 6). Therefore, an electrolyte is less likely to be pushed out to the outside from the negative electrode, and thus, salt concentration unevenness in an electrode assembly is less likely to occur. Therefore, in the second SOC region, the speed of progress of deterioration of the battery (specifically, an increase in internal resistance of the battery) can fall within a permissible range, even when the charging current to the battery is set to be relatively large. Thus, according to the method in (1) above, high rate deterioration of the lithium ion battery can be suppressed.
(2) The determining (second step) includes setting a C rate of the charging current to be 1.5 C or more in the second SOC region and setting the charging current in the second SOC region to be 1.25 or more times as large as the charging current in the first or third SOC region.
   According to the method in (2) above, based on results (see Fig. 13) of an evaluation test conducted by the inventors, a numerical range of the C rate of the charging current is defined to be more than 1.5 C or less than 1.5 C, and a numerical range of a ratio of the charging current among the SOC regions is defined. As a result, high rate deterioration of the lithium ion battery can be suppressed more suitably.
(3) A charging system according to another aspect of the present disclosure includes: a battery that is a lithium ion battery including a graphite-containing negative electrode; and a controller that controls a charging current to the battery. A stage structure of the graphite is classified into a stage 1 to a stage 4. The battery includes: a first SOC region where the stage 4 and the stage 3 coexist; a second SOC region where the stage 3 and the stage 2 coexist; and a third SOC region where the stage 2 and the stage 1 coexist. The controller estimates an SOC of the battery based on at least one of a voltage and a current of the battery. The controller determines the charging current in accordance with the SOC of the battery such that the charging current in the second SOC region is larger than the charging current in the first and third SOC regions.

According to the configuration in (3) above, high rate deterioration of the lithium ion battery can be suppressed, similarly to the method in (1) above.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 schematically shows an overall configuration of a charging system according to an embodiment of the present disclosure.
Fig. 2 schematically shows configurations of a vehicle and a charging facility according to the present embodiment.
Fig. 3 shows a configuration of a battery in more detail.
Fig. 4 shows a configuration of a cell in more detail.
Fig. 5 is a conceptual diagram for illustrating a stage structure of a graphite negative electrode.
Fig. 6 shows a change in volume of the negative electrode during charging of the battery.
Fig. 7 shows a relationship between an SOC of the battery and a maximum charging current to the battery in the present embodiment.
Fig. 8 is a flowchart showing a method for charging the battery according to the present embodiment.
Fig. 9 is a time chart showing a current pattern used in a first evaluation test.
Fig. 10 shows results of the first evaluation test.
Fig. 11 is a time chart showing charging current patterns used in a second evaluation test.
Fig. 12 shows results of the second evaluation test.
Fig. 13 shows results of a third evaluation test.

### DESCRIPTION OF THE PREFERRED EMBODIMENTS

An embodiment of the present disclosure will be described in detail hereinafter with reference to the drawings, in which the same or corresponding portions are denoted by the same reference characters and description thereof will not be repeated.

In the embodiment described below, a charging system according to the present disclosure is used to charge a non-aqueous electrolyte secondary battery mounted on a vehicle. However, applications of the charging system according to the present disclosure are not limited to the use in a vehicle, and the charging system according to the present disclosure may be fixed, for example.

### [Embodiment]

### <Configuration of Vehicle>

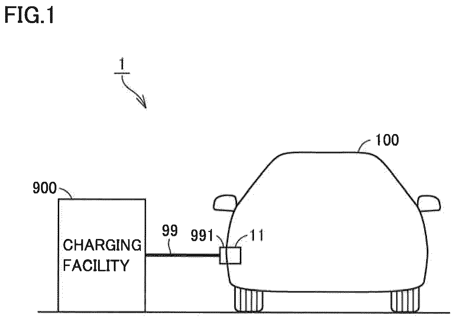

Fig. 1 schematically shows an overall configuration of a charging system according to an embodiment of the present disclosure. Referring to Fig. 1, a charging system 1 includes a vehicle 100 and a charging facility (such as a charging stand) 900 provided outside vehicle 100.

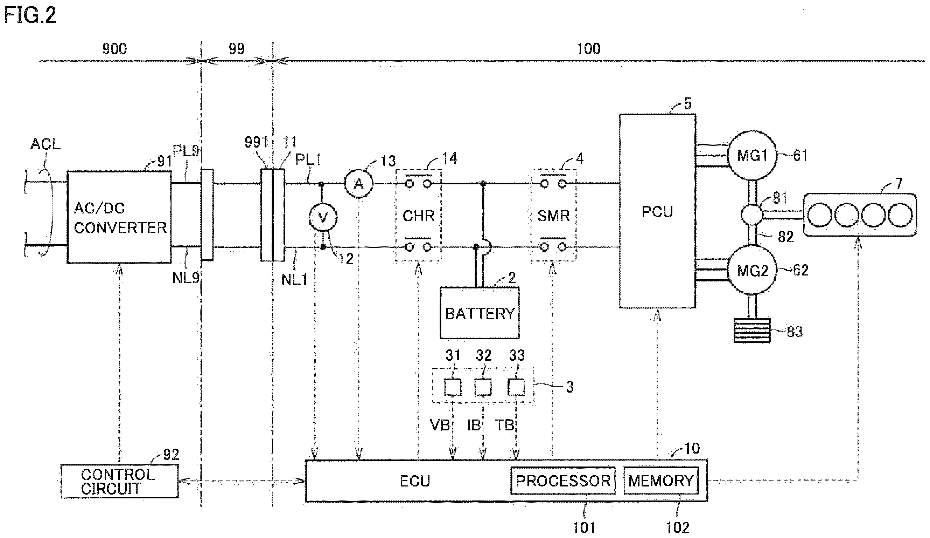

Vehicle 100 is typically a plug-in hybrid vehicle (PHV). Vehicle 100 performs "plug-in charging" for charging a battery 2 (see Fig. 2) mounted on vehicle 100, using electric power supplied from charging facility 900 through a charging cable 99. However, vehicle 100 is not limited to the plug-in hybrid vehicle, and may be any other type of electric powered vehicle that performs plug-in charging. Specifically, vehicle 100 may be an electric vehicle (EV), or may be a plug-in fuel cell vehicle (PFCV).

Fig. 2 schematically shows configurations of vehicle 100 and charging facility 900 according to the present embodiment. In the present embodiment, charging facility 900 is a charger that performs direct current (DC) charging, and is adapted to so-called "quick charging". Charging facility 900 converts AC power supplied from a power supply system (not shown) into high-voltage DC power that can be charged to vehicle 100. Charging facility 900 includes a power line ACL, an AC/DC converter 91, power feeding lines PL9 and NL9, and a control circuit 92.

Power line ACL is electrically connected to the power supply system. Power line ACL transmits the AC power from the power supply system to AC/DC converter 91.

AC/DC converter 91 converts the AC power on power line ACL into DC power for charging battery 2 mounted on vehicle 100. The power conversion by AC/DC converter 91 may be performed by a combination of AC/DC conversion for power factor improvement and DC/DC conversion for voltage level adjustment. The DC power output from AC/DC converter 91 is supplied to power feeding line PL9 on the positive electrode side and power feeding line NL9 on the negative electrode side.

Control circuit 92 includes a processor, a memory, and an input and output port (all are not shown). Control circuit 92 controls the power conversion operation by AC/DC converter 91, based on a voltage between power feeding line PL9 and power feeding line NL9, communication with vehicle 100, and a map and a program stored in the memory.

Vehicle 100 includes an inlet 11, charging lines PL1 and NL1, a voltage sensor 12, a current sensor 13, a charging relay 14, battery 2, a monitoring unit 3, a system main relay (SMR) 4, a power control unit (PCU) 5, motor generators 61 and 62, an engine 7, a power split device 81, a drive shaft 82, a drive wheel 83, and an electronic control unit (ECU) 10.

A connector 991 provided at a tip of charging cable 99 is connected to inlet 11. More specifically, connector 991 is inserted into inlet 11 with mechanical coupling such as fitting, so that electrical connection between power feeding line PL9 of charging cable 99 and a positive-electrode-side contact point of inlet 11 is ensured and electrical connection between power feeding line NL9 and a negative-electrode-side contact point of inlet 11 is ensured. Furthermore, when charging cable 99 is connected to inlet 11, ECU 10 of vehicle 100 and control circuit 92 of charging facility 900 can mutually receive and transmit various types of signals, instructions and data. Communication in accordance with a prescribed communication standard such as CAN (Controller Area Network) or communication using an analog signal through an analog control line can be used as the above-described bidirectional communication.

Charging lines PL1 and NL1 are provided between inlet 11 and battery 2, and transmits the DC power from inlet 11 to battery 2.

Between inlet 11 and charging relay 14, voltage sensor 12 is electrically connected between charging line PL1 and charging line NL1. Voltage sensor 12 detects a voltage between charging line PL1 and charging line NL1, and outputs the result of detection to ECU 10. Between inlet 11 and charging relay 14, current sensor 13 is electrically connected to charging line PL1. Current sensor 13 detects a current flowing through charging line PL1, and outputs the result of detection to ECU 10. Based on the results of detection by voltage sensor 12 and current sensor 13, ECU 10 can calculate supply power (including a supply current) from charging facility 900 to vehicle 100.

Charging relay 14 is electrically connected to charging lines PL1 and NL1. Charging relay 14 is opened/closed in accordance with a control instruction from ECU 10. When charging relay 14 is closed, power transmission from inlet 11 to battery 2 becomes possible.

Battery 2 is an assembled battery including a plurality of cells 21. Each cell 21 is a non-aqueous electrolyte secondary battery, i.e., a lithium ion battery. Battery 2 stores electric power for driving motor generators 61 and 62, and supplies electric power to motor generators 61 and 62 through PCU 5. Furthermore, battery 2 is charged with the supply power from charging facility 900 during plug-in charging of vehicle 100. In addition, battery 2 receives generated electric power through PCU 5 and is charged with the generated electric power during power generation by motor generators 61 and 62.

Monitoring unit 3 includes a voltage sensor 31, a current sensor 32 and a temperature sensor 33. Voltage sensor 31 measures a voltage VB of each of the plurality of cells 21. Current sensor 32 measures a current IB input and output to and from battery 2. Temperature sensor 33 measures a temperature TB of each block (module) composed of a plurality of cells 21. Each sensor outputs a signal indicating the result of measurement to ECU 10. Based on the signal from voltage sensor 31 and/or the signal from current sensor 32, ECU 10 estimates a state of charge (SOC) of battery 2.

A unit of monitoring by each sensor in monitoring unit 3 is not particularly limited. The unit of monitoring may be, for example, a cell unit or a block unit. In the following description, for ease of understanding, battery 2 as a whole will be regarded as the unit of monitoring, without particularly taking an internal configuration of battery 2 into consideration.

SMR 4 is electrically connected to a power line that connects battery 2 and PCU 5. SMR 4 switches between supply and cut-off of electric power between battery 2 and PCU 5 in accordance with a control instruction from ECU 10.

PCU 5 performs bidirectional power conversion between battery 2 and motor generators 61 and 62 in accordance with a control instruction from ECU 10. PCU 5 controls states of motor generators 61 and 62 individually. PCU 5 includes, for example, two inverters and a converter (all are not shown). The two inverters are provided to correspond to motor generators 61 and 62. The converter boosts a DC voltage supplied to each inverter to a voltage equal to or higher than an output voltage of battery 2.

Each of motor generators 61 and 62 is an AC rotating electric machine, and is a three-phase AC synchronous motor including a rotor in which a permanent magnet (not shown) is embedded, for example. Motor generator 61 is mainly used as a generator driven by engine 7 through power split device 81. Electric power generated by motor generator 61 is supplied to motor generator 62 or battery 2 through PCU 5. Motor generator 62 operates mainly as a motor. Motor generator 62 is driven by at least one of the electric power from battery 2 and the electric power generated by motor generator 61, and the driving force of motor generator 62 is transmitted to drive shaft 82. In contrast, during braking of vehicle 100 or during reduction in acceleration on a downward slope, motor generator 62 operates as a generator and performs regenerative power generation. Electric power generated by motor generator 62 is supplied to battery 2 through PCU 5.

Engine 7 is, for example, a gasoline engine or a diesel engine. Engine 7 outputs motive power by converting combustion energy generated when a mixture of air and fuel is burned into kinetic energy of movable elements such as a piston and a rotor.

Power split device 81 includes, for example, a planetary gear mechanism (not shown) having three rotation shafts of a sun gear, a carrier and a ring gear. Power split device 81 splits the motive power output from engine 7 into motive power for driving motor generator 61 and motive power for driving drive wheel 83.

Similarly to control circuit 92 of charging facility 900, ECU 10 includes a processor 101 such as a central processing unit (CPU), a memory 102 such as a read only memory (ROM) and a random access memory (RAM), and an input and output port (not shown) for inputting and outputting various types of signals. ECU 10 performs various types of processes for controlling vehicle 100 to a desired state, based on the signal received from each sensor and the program and the map stored in memory 102.

More specifically, during plug-in charging of vehicle 100, ECU 10 communicates with control circuit 92 of charging facility 900 through charging cable 99, and adjusts power supply from charging facility 900 to vehicle 100. As a result, charging control for battery 2 is implemented. During traveling of vehicle 100, ECU 10 outputs a control instruction to PCU 5 and engine 7, to thereby control charging and discharging of battery 2. Details of charging control for battery 2 will be described below.

ECU 10 may be divided into a plurality of ECUs for each function. For example, ECU 10 can be divided into a battery ECU that monitors a state of battery 2, an HVECU that controls PCU 5, and an engine ECU that controls engine 7 (all are not shown).

ECU 10 corresponds to "controller" according to the present disclosure. However, control circuit 92 on the charging facility 900 side may be "controller" according to the present disclosure. Alternatively, both ECU 10 and control circuit 92 may be "controller" according to the present disclosure.

The configuration of "charging system" according to the present disclosure is not limited to the configuration example shown in Fig. 2. For example, when vehicle 100 is adapted to AC charging (so-called normal charging), a charger that performs AC/DC conversion may be provided in vehicle 100 in place of charging facility 900.

### <Configuration of Battery>

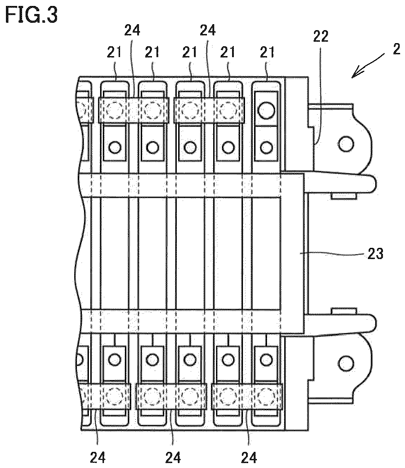

Fig. 3 shows a configuration of battery 2 in more detail. Referring to Fig. 3, battery 2 includes a plurality of cells 21, a pair of end plates 22, a restraint band 23, and a plurality of bus bars 24. As described above, the number of the cells is not particularly limited.

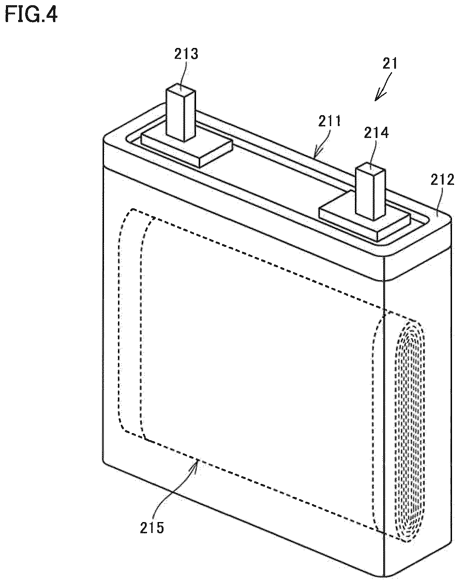

Each of the plurality of cells 21 includes a battery case 211 (see Fig. 4) having, for example, a flat rectangular shape (substantially rectangular parallelepiped shape). The plurality of cells 21 are stacked such that adjacent side surfaces each having the largest area face each other with a distance therebetween. Fig. 3 partially shows one end, in a stacking direction, of a stacked body formed by stacking the plurality of cells 21. The pair of end plates 22 (only one is shown in Fig. 3) are arranged to face one end and the other end in the stacking direction, respectively. The pair of end plates 22 are restrained by restraint band 23 in a state where all cells 21 are sandwiched between the pair of end plates 22.

Each cell 21 has a positive electrode terminal 213 and a negative electrode terminal 214 (see Fig. 4). Positive electrode terminal 213 of a cell is arranged to face negative electrode terminal 214 of a cell adjacent to the cell. Positive electrode terminal 213 of the cell and negative electrode terminal 214 of the adjacent cell are fastened by bus bar 24, using a bolt and a nut (both are not shown). As a result, the plurality of cells 21 are connected in series.

### <Configuration of Cell>

Fig. 4 shows a configuration of cell 21 in more detail. Cell 21 in Fig. 4 is shown such that the interior thereof can be viewed in a see-through manner.

Referring to Fig. 4, an upper surface of battery case 211 is sealed by a lid 212. One end of each of positive electrode terminal 213 and negative electrode terminal 214 protrudes from lid 212 to the outside. The other ends of positive electrode terminal 213 and negative electrode terminal 214 are connected to an internal positive electrode terminal and an internal negative electrode terminal (both are not shown), respectively, in battery case 211. An electrode assembly 215 is accommodated in battery case 211. Electrode assembly 215 is formed by stacking a positive electrode and a negative electrode with a separator interposed therebetween, to thereby obtain a stacked body, and winding the stacked body. An electrolyte is retained in the positive electrode, the negative electrode and the separator.

A configuration and a material that are conventionally known as a positive electrode, a separator and an electrolyte of a lithium ion secondary battery can be used for the positive electrode, the separator and the electrolyte. By way of example, a ternary (Li(Ni-Mn-Co)O₂) material obtained by replacing a part of lithium cobalt oxide (LiCoO₂) with nickel and manganese can be used for the positive electrode.

The negative electrode includes graphite. Alternatively, a composite electrode of graphite and a silicon-based material (Si or SiO) may be used for the negative electrode. In this case, a content of the graphite is preferably not less than 80 [wt%].

Polyolefin (e.g., polyethylene or polypropylene) can be used for the separator. The electrolyte includes an organic solvent (e.g., a mixed solvent of dimethyl carbonate (DMC) and ethyl methyl carbonate (EMC) and ethylene carbonate (EC)), a lithium salt (e.g., LiPF₆), an additive (e.g., lithium bis(oxalate)borate (LiBOB) or Li[PF₂(C₂O₄)₂]), and the like.

The configuration of the cell is not limited to the above-described example. For example, the electrode assembly may have a stacked structure, not a wound structure. In addition, the battery case is not limited to the rectangular-shaped battery case, and a cylindrically-shaped battery case or a battery case of a laminate type can also be used.

In charging system 1 configured as described above, there is a demand for suppressing deterioration of battery 2 due to charging. When emphasis is placed on suppression of deterioration of battery 2, a charging current to battery 2 during plug-in charging is set to be sufficiently small. In this case, however, the charging time may become longer and the user's convenience may decrease. In contrast, when emphasis is placed on a reduction in charging time and the charging current is set to be excessively large, a rate of increase (degree of increase) in internal resistance of battery 2 may become too fast and high rate deterioration of battery 2 may progress. In view of such circumstances, in the present embodiment, a maximum current (hereinafter, also referred to as "maximum charging current") Imax that can be charged to battery 2 is determined in accordance with the SOC of battery 2. This charging control technique will be described in detail below.

### <Stage Structure of Graphite Negative Electrode>

When graphite is used as a negative electrode material, lithium ions are occluded between layers of a layered structure of the graphite. The graphite has a stage structure in which lithium ions are regularly occluded between specific layers.

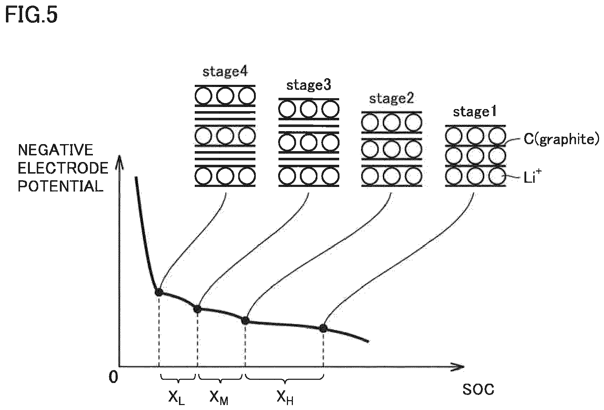

Fig. 5 is a conceptual diagram for illustrating the stage structure of the graphite negative electrode. In Fig. 5, the horizontal axis represents the SOC of the lithium ion battery. However, the horizontal axis may represent a negative electrode capacity (capacity per unit weight of the negative electrode) [mAh/g]. The vertical axis represents a negative electrode potential.

Referring to Fig. 5, the stage structure is classified into four types of stages, i.e., a stage 1 to a stage 4. In the stage 1, lithium ions are occluded in each layer of the graphite. In the stage 2, one layer where lithium ions are not occluded is present between two layers where lithium ions are occluded. In the stage 3, two layers where lithium ions are not occluded are present between two layers where lithium ions are occluded. In the stage 4, three layers where lithium ions are not occluded are present between two layers where lithium ions are occluded. Therefore, the stage n (n=1 to 4) refers to a state in which (n-1) layers where lithium ions are not occluded are present between two layers where lithium ions are occluded.

The SOC of the lithium ion battery can be classified into three SOC regions in accordance with the stage structure of the graphite negative electrode. These SOC regions are denoted as "low SOC region X_{L}", "medium SOC region X_{M}" and "high SOC region X_{H}". In low SOC region X_{L}, the graphite takes a state in which the stage 3 and the stage 4 mainly coexist. In medium SOC region X_{M}, the graphite takes a state in which the stage 2 and the stage 3 mainly coexist. In high SOC region X_{H}, the graphite takes a state in which the stage 1 and the stage 2 mainly coexist. Low SOC region X_{L}, medium SOC region X_{M} and high SOC region X_{H} correspond to "first SOC region", "second SOC region" and "third SOC region" according to the present disclosure, respectively.

During charging of the lithium ion battery, the stage structure of the graphite negative electrode changes from the stage 4 through the stage 3 and the stage 2 to the stage 1, as the SOC of the lithium ion battery increases. With such a change in stage structure of the graphite negative electrode, a volume of the graphite negative electrode changes.

### <Change in Volume of Graphite Negative Electrode>

Fig. 6 shows a change in volume of the negative electrode during charging of battery 2. In Fig. 6, the horizontal axis represents the SOC of battery 2. The vertical axis in the upper graph represents a negative electrode potential (single electrode potential of the negative electrode) [V] with reference to a potential of metallic lithium. The vertical axis in the lower graph represents a load [kgf] applied between adjacent cells 21 in battery 2.

A known method, e.g., a method based on the number of lithium on an outermost surface of a negative electrode active material can be used as a method for obtaining the negative electrode potential. Specifically, the number of lithium input and output to and from the negative electrode active material is first calculated from current IB and temperature TB of battery 2. Current IB is divided by an electrode plate area of the positive electrode and the negative electrode, to thereby obtain a current density. The current density is multiplied by an operation period and a prescribed inflow coefficient, to thereby obtain an amount of electric charge input and output to and from the negative electrode active material. Since an amount of electric charge of each lithium ion is known, the number of lithium input and output to and from the negative electrode active material can be calculated by dividing the amount of electric charge input and output to and from the negative electrode active material by the amount of electric charge of the lithium ion. Furthermore, in consideration of, for example, diffusion of the lithium ions into the negative electrode active material, the number of lithium on the outermost surface of the negative electrode active material is calculated from the number of lithium input and output to and from the negative electrode active material. Then, a surface potential is calculated from the calculated number of lithium on the outermost surface of the negative electrode active material, and the surface potential can be defined as the negative electrode potential. The load between cells 21 can be measured by placing a surface pressure sensor (not shown) between adjacent two cells 21.

As shown in Fig. 6, as charging of battery 2 progresses and the SOC of battery 2 increases, the negative electrode potential decreases monotonously, whereas the load between cells 21 increases monotonously. The increase in load is due to an increase in volume of the electrode assembly caused by expansion of the graphite negative electrode.

When attention is focused on a rate (first derivation) of increase in load due to the increase in SOC, the rate of increase in load when the stage structure changes from the stage 3 to the stage 2 is lower than the rate of increase in load when the stage structure changes from the stage 4 to the stage 3. In addition, the rate of increase in load when the stage structure changes from the stage 3 to the stage 2 is lower than the rate of increase in load when the stage structure changes from the stage 2 to the stage 1, In other words, when charging of battery 2 progresses, a volume change rate (so-called expansion rate) of the negative electrode in medium SOC region X_{M} is lower than the volume change rate of the negative electrode in low SOC region X_{L} and high SOC region X_{H}. In the present embodiment, the charging current to battery 2 is controlled, technically based on the above-described volume change rate of the graphite negative electrode.

### <Control of Charging Current>

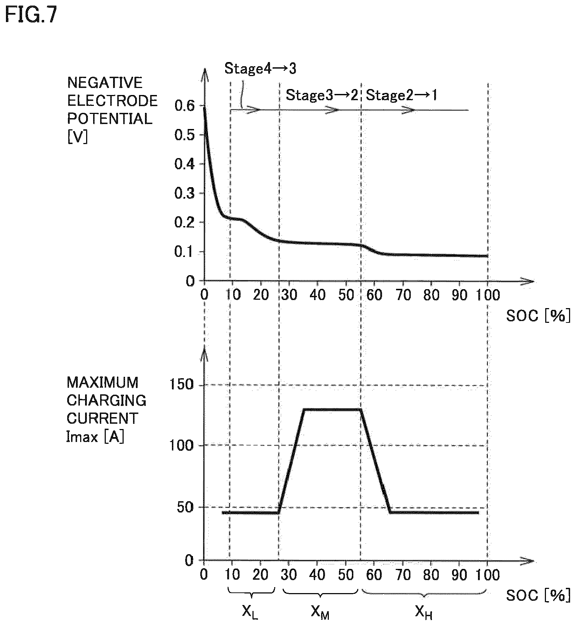

Fig. 7 shows a relationship between the SOC of battery 2 and maximum charging current Imax to battery 2 in the present embodiment. In Fig. 7, the horizontal axis represents the SOC of battery 2. The vertical axis in the upper graph represents the negative electrode potential. This corresponds to the graph described with reference to Fig. 6, for the sake of clarity. The vertical axis in the lower graph represents maximum charging current Imax [A] to battery 2. With regard to a sign of a current I input and output to and from battery 2, a direction of charging of battery 2 is defined as positive.

In the present embodiment, as shown in Fig. 7, maximum charging current Imax in medium SOC region X_{M} is larger than maximum charging current Imax in low SOC region X_{L} or high SOC region X_{H}. The above-described relationship is preliminarily defined and stored in memory 102 of ECU 10 as a map (which may be a table).

When the negative electrode expands, the electrolyte retained in the negative electrode is pushed out of the negative electrode. As an amount of expansion of the negative electrode becomes larger, an amount of the pushed-out electrolyte becomes larger. The above-described movement of the electrolyte may result in uneven distribution of a lithium ion concentration (salt concentration unevenness) in the electrode assembly. As a result, high rate deterioration of battery 2 may progress. As described above, the volume change rate of the negative electrode in medium SOC region X_{M} is lower than the volume change rate of the negative electrode in low SOC region X_{L} and high SOC region X_{H}. Therefore, in medium SOC region X_{M}, push-out of the electrolyte from the negative electrode is relatively less likely to occur. Thus, uneven distribution of the lithium ion concentration is less likely to occur. That is, high rate deterioration of battery 2 is less likely to progress. Therefore, as compared with low SOC region X_{L} and high SOC region X_{H}, in medium SOC region X_{M}, the rate of increase in internal resistance of battery 2 can fall within a permissible range, even when maximum charging current Imax is set to be large. Thus, according to the present embodiment, a reduction in charging time and suppression of deterioration of battery 2 due to charging can both be achieved.

### <Charging Control Flow>

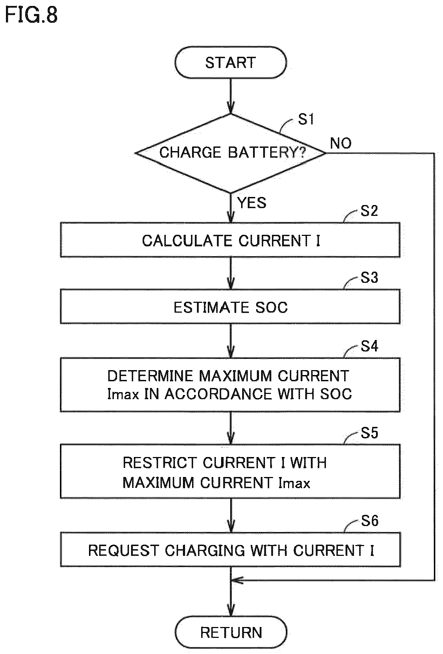

Fig. 8 is a flowchart showing a method for charging battery 2 according to the present embodiment. This flowchart is invoked from a main routine (not shown) and performed every time a prescribed control period elapses. Each step is basically implemented by software processing by ECU 10. However, each step may be implemented by hardware processing by an electronic circuit formed in ECU 10. In the following description, each step will be abbreviated as "S".

Referring to Fig. 8, in S1, ECU 10 determines whether or not to perform plug-in charging of battery 2. Specifically, when charging cable 99 is connected to inlet 11 (immediately before plug-in charging is started or when plug-in charging is in execution), ECU 10 can make a determination of YES in S1. When plug-in charging of battery 2 is not performed (NO in S1), ECU 10 skips the subsequent steps and returns the process to the main routine.

In S2, ECU 10 calculates current I to be charged to battery 2. More specifically, ECU 10 determines a pattern of the current charged to battery 2, based on negotiation with control circuit 92 of charging facility 900. Based on the determined current pattern, ECU 10 calculates charging current I at the current time (current to be charged).

In S3, ECU 10 estimates the SOC of battery 2 based on at least one of voltage VB and current IB of battery 2. A known method such as a method using a predetermined SOC-OCV characteristic curve or a method for summing the currents input and output to and from battery 2 can be used as a method for estimating the SOC.

In S4, ECU 10 determines maximum charging current Imax to battery 2 based on the SOC of battery 2, by referring to a map (see, for example, the lower graph in Fig. 7) indicating the relationship between the SOC of battery 2 and maximum charging current Imax.

In S5, ECU 10 restricts charging current I to battery 2 with maximum charging current Imax. Specifically, when charging current I to battery 2 (value calculated in S2) is more than or equal to maximum charging current Imax, ECU 10 replaces charging current I to battery 2 with maximum charging current Imax (I=Imax). In contrast, when charging current I to battery 2 is less than maximum charging current Imax, ECU 10 uses charging current I to battery 2.

In S6, ECU 10 performs plug-in charging control of battery 2 such that charging current I restricted in S25 is charged to battery 2. For example, during plug-in charging of vehicle 100, a parameter about a charging condition for battery 2 is exchanged between vehicle 100 and charging facility 900. At this time, ECU 10 sets a current value (or a receivable maximum current value) that is required to be supplied from charging facility 900 to vehicle 100 at the value calculated in S5. Thereafter, the process is returned to the main routine, and thus, a series of process is repeated for each prescribed control period.

The inventors conducted three types of evaluation tests (first to third evaluation tests) in order to evaluate the method for charging battery 2 according to the present embodiment. Results of these evaluation tests will be described below in sequence.

### <First Evaluation Test>

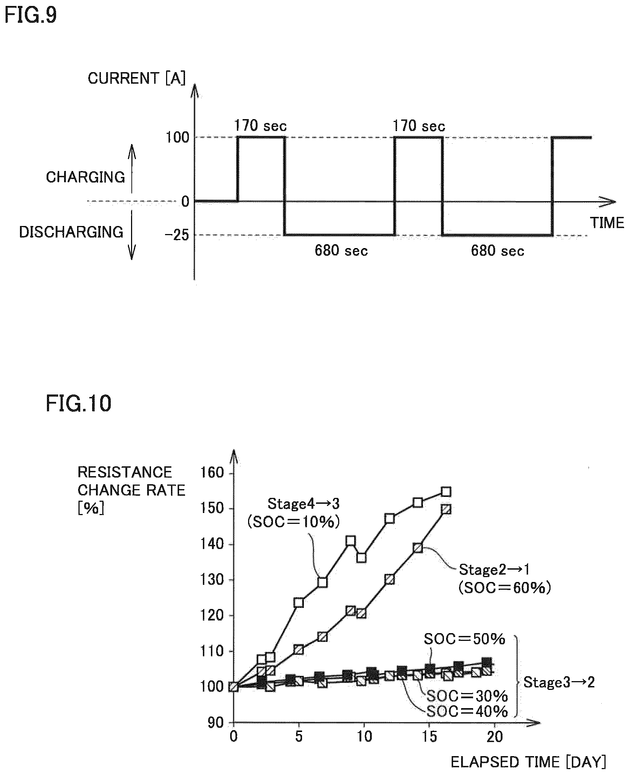

Fig. 9 is a time chart showing a current pattern used in the first evaluation test. In Fig. 9, the horizontal axis represents the elapsed time. The vertical axis represents the current charged to and discharged from battery 2. Each of current values described below refers to a value of the current charged to and discharged from each cell 21.

In the first evaluation test, as shown in Fig. 9, the alternate passage of a charging current of 100 A for 170 seconds and a discharging current of 25 A for 680 seconds was repeated. The discharging current is a normal level current, whereas the charging current is a high rate current. The high rate charging current may result in salt concentration unevenness in the electrode assembly. However, since an amount of electric charge (amount of electricity) [A●s] charged to battery 2 is equal to an amount of electric charge discharged from battery 2, the SOC of battery 2 repeatedly increases and decreases in a prescribed region.

In the first evaluation test, five samples of batteries 2 were prepared and these samples were charged and discharged in different SOC regions. Specifically, the first sample was charged and discharged at around SOC=10%, to thereby change the stage structure of the graphite negative electrode between the stage 4 and the stage 3. The second sample was charged and discharged at around SOC=30%, the third sample was charged and discharged at around SOC=40%, and the fourth sample was charged and discharged at around SOC=50%. As a result, as for the second to fourth samples, the stage structure of the graphite negative electrode was changed between the stage 4 and the stage 3. The fifth sample was charged and discharged at around SOC=60%, to thereby change the stage structure of the graphite negative electrode between the stage 2 and the stage 1. Then, a degree of progress of deterioration of battery 2 due to charging and discharging was quantitatively evaluated based on the rate of change in internal resistance (resistance change rate) of battery 2. The resistance change rate refers to a ratio [%] of an internal resistance after the start of charging to an internal resistance before the start of charging.

Fig. 10 shows results of the first evaluation test. In Fig. 10, the horizontal axis represents the elapsed time (number of days elapsed) from the start of charging and discharging of battery 2. The vertical axis represents the resistance change rate from the start of charging and discharging of battery 2.

Referring to Fig. 10, when the stage structure of the graphite negative electrode was changed between the stage 4 and the stage 3 (SOC=10%) or when the stage structure of the graphite negative electrode was changed between the stage 2 and the stage 1 (SOC=60%), the internal resistance of battery 2 increased rapidly. Specifically, the internal resistance of battery 2 reached 150% or more of the original internal resistance after charging and discharging for 15 days.

In contrast, when the stage structure of the graphite negative electrode was changed between the stage 4 and the stage 3 (SOC=30%, 40%, 50%), the amount of increase in internal resistance of battery 2 was approximately 5% even after charging and discharging were repeated for 20 days. That is, the internal resistance of battery 2 hardly increased.

### <Second Evaluation Test>

In the second evaluation test, two samples of batteries 2 each having an SOC adjusted to a prescribed value (in this example, 10%) were prepared. One battery 2 was subjected to a charging and discharging cycle of charging battery 2 to a fully charged state in accordance with a general charging pattern (comparative example), and then, discharging battery 2 at a small current (low rate) to return to the original state. The other battery 2 was similarly subjected to the charging and discharging cycle using a charging pattern in the present embodiment. In either case, the number of charging cycles was set at 100.

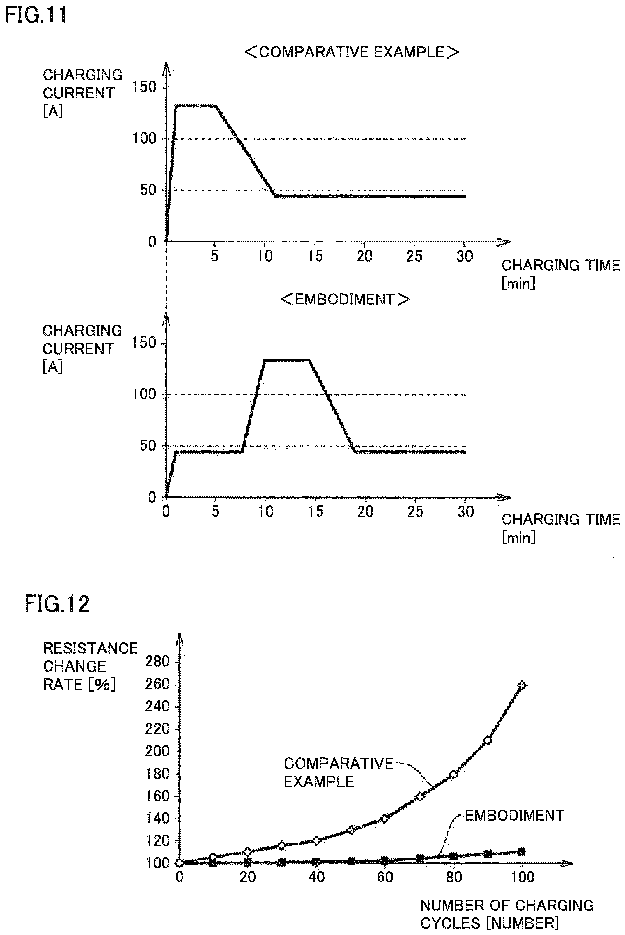

Fig. 11 is a time chart showing the charging current patterns used in the second evaluation test. In Fig. 11, the horizontal axis represents the elapsed time from the start of charging of battery 2. The vertical axis in the upper graph represents charging current I to battery 2 in the comparative example, and the vertical axis in the lower graph represents charging current I to battery 2 in the present embodiment.

Referring to Fig. 11, in the comparative example, charging current I to battery 2 was the largest immediately after the start of charging. Charging current I was gradually reduced as charging of battery 2 progressed.

In contrast, in the present embodiment, charging current I to battery 2 was restricted to a relatively small value (not more than 50 A) at the start of charging. Charging in this restricted state was continued for about 7 minutes, and then, charging current I was increased to about 130 A. A maximum value of the current charged to the battery in the present embodiment was equal to a maximum value in the comparative example (about 130 A). Thereafter, as charging of battery 2 progressed, charging current I was reduced similarly to the comparative example.

Fig. 12 shows results of the second evaluation test. In Fig. 12, the horizontal axis represents the number of charging cycles. The vertical axis represents the resistance change rate of battery 2.

Referring to Fig. 12, when a comparison is made under a condition that the number of charging cycles is the same, it can be seen that an amount of increase in resistance change rate (≤110%) of battery 2 in the present embodiment is significantly smaller than an amount of increase in resistance change rate (≥250%) of battery 2 in the comparative example.

### <Third Evaluation Test>

In the third evaluation test, charging of battery 2 was repeated 100 times in accordance with the charging current pattern in the present embodiment (see the lower graph in Fig. 11), and then, the resistance change rate of battery 2 was measured.

Fig. 13 shows results of the third evaluation test. Fig. 13 shows the current patterns applied to battery 2 and the measurement results of the corresponding resistance change rate of battery 2 for five Examples 1 to 5 in the present embodiment and two Comparative Examples 1 and 2. The charging current in the SOC region where the stage structure of the graphite negative electrode changes from the stage 4 to the stage 3 during charging of battery 2 is denoted as I₄₃, the charging current in the SOC region where the stage structure of the graphite negative electrode changes from the stage 3 to the stage 2 is denoted as I₃₂, and the charging current in the SOC region where the stage structure of the graphite negative electrode changes from the stage 2 to the stage 1 is denoted as I₂₁. The charging current in Fig. 13 refers to a value obtained by converting the charging current to battery 2 into a C rate.

In Comparative Examples 1 and 2, the charging current to battery 2 in the SOC region where the stage structure of the graphite negative electrode changed from the stage 4 to the stage 3 was set to be the largest (see the upper graph in Fig. 11). In this case, the resistance change rate of battery 2 after the 100 charging cycles increased significantly. Specifically, when charging current I to battery 2 was 2.0 C or more, the amount of increase in resistance change rate of battery 2 was particularly large and reached about 250% (243% or 264%).

In contrast, in Examples 1 to 5, the C rate of the charging current to battery 2 in the SOC region where the stage structure of the graphite negative electrode changed from the stage 3 to the stage 2 was set to be 1.5 C or more. This charging current was 1.25 or more times as large as the charging current in the SOC region where the stage structure of the graphite negative electrode changed from the stage 4 to the stage 3 (and the SOC region where the stage structure of the graphite negative electrode changed from the stage 2 to the stage 1). This made it possible to suppress the resistance change rate of battery 2 at approximately 110% while reducing the charging time.

As described above, in the present embodiment, maximum charging current Imax to battery 2 is determined in accordance with the SOC of battery 2. Specifically, the charging current to battery 2 in the SOC region where the stage structure of the graphite negative electrode changes from the stage 3 to the stage 2 due to charging of battery 2 is set to be larger than the charging current to battery 2 in the other SOC region (the SOC region where the stage structure of the graphite negative electrode changes from the stage 4 to the stage 3 or the SOC region where the stage structure of the graphite negative electrode changes from the stage 2 to the stage 1). The expansion rate of the negative electrode is lower in the SOC region where the stage structure of the graphite negative electrode changes from the stage 3 to the stage 2 than in the other SOC region (see Fig. 6). Therefore, push-out of the electrolyte from the negative electrode due to charging is less likely to occur. As a result, uneven distribution of the lithium ion concentration (salt concentration unevenness) in the electrode assembly is less likely to occur, and thus, high rate deterioration of battery 2 can be suitably suppressed.

While the embodiment of the present disclosure has been described, it should be understood that the embodiment disclosed herein is illustrative and non-restrictive in every respect. The scope of the present disclosure is defined by the terms of the claims and is intended to include any modifications within the scope and meaning equivalent to the terms of the claims.

## Claims

1. A method for charging a battery (2) that is a lithium ion battery including a graphite-containing negative electrode,
a stage structure of the graphite being classified into a stage 1 to a stage 4,
the battery (2) including:
a first SOC region where the stage 4 and the stage 3 coexist;
a second SOC region where the stage 3 and the stage 2 coexist; and
a third SOC region where the stage 2 and the stage 1 coexist,
the method comprising:
estimating an SOC of the battery (2) based on at least one of a voltage and a current of the battery (2); and
determining a charging current to the battery (2) in accordance with the SOC of the battery (2) such that the charging current in the second SOC region is larger than the charging current in the first and third SOC regions.

2. The method for charging the battery (2) according to claim 1, wherein
the determining includes setting a C rate of the charging current to be 1.5 C or more in the second SOC region and setting the charging current in the second SOC region to be 1.25 or more times as large as the charging current in the first or third SOC region.

3. A charging system (1) comprising:
a battery (2) that is a lithium ion battery including a graphite-containing negative electrode; and
a controller (10) that controls a charging current to the battery (2), wherein
a stage structure of the graphite is classified into a stage 1 to a stage 4,
the battery (2) includes:
a first SOC region where the stage 4 and the stage 3 coexist;
a second SOC region where the stage 3 and the stage 2 coexist; and
a third SOC region where the stage 2 and the stage 1 coexist, and the controller (10)
estimates an SOC of the battery (2) based on at least one of a voltage and a current of the battery (2), and
determines the charging current in accordance with the SOC of the battery (2) such that the charging current in the second SOC region is larger than the charging current in the first and third SOC regions.
